# EUROPEAN PATENT APPLICATION

(11) **EP 3 883 341 A1**
(43) Date of publication of application: **22.09.2021**
(21) Application number: 20164582.7
(22) Date of filing: 20.03.2020
(51) Int. Cl.: H05B 6/06, H05B 1/02

(54) **COOKING APPLIANCE WITH AT LEAST ONE CARRYING PLATE AND METHOD FOR ASSEMBLING A VIBRATION SENSOR**

(71) Applicant: ELECTROLUX APPLIANCES AKTIEBOLAG, 105 45 Stockholm (SE)
(72) Inventor: NEUKAMM, Alwin, 91541 Rothenburg ob der Tauber (DE); WASINKIEWICZ, Lukasz, 91541 Rothenburg ob der Tauber (DE)
(74) Representative: Electrolux Group Patents

(57) **Abstract**

The present invention relates to a cooking appliance with at least one carrying plate (3) adapted to receive cookware placed thereon, in particular a cooking hob (1) with a top plate. At least one sensing means for the detection of vibration is comprised. The vibration is generated when food to be cooked and/or cooking adjuvant inside of the cookware is heated up. The food to be cooked and/or cooking adjuvant may be a cooking liquid. A vibration sensor is attached to the carrying plate (3) by way of fixation means which prevent relative movement between the vibration sensor and the carrying plate (3), in particular in the direction towards and/or away from each other.

Further, a method for assembling a vibration sensor to a carrying plate (3) of a cooking appliance, particularly to a top plate of a cooking hob (1), is disclosed. The carrying plate (3) transmits vibration movements from a cookware to the vibration sensor. The assembly comprises the assembling steps:
- a first rigid frame part (23) is rigidly connected to the carrying plate (3), preferably in a first assembling step; and
- the vibration sensor is connected to the first rigid frame part (23) in a way that prevents relative movement between vibration sensor and carrying plate (3), in particular in the direction towards and/or away from each other, preferably in a second assembling step.

## Description

The present invention relates to a cooking appliance with at least one carrying plate adapted to receive cookware placed thereon, in particular to a cooking hob with a top plate. More specifically, the invention relates to a respective cooking appliance which comprises at least one sensing means for the detection of vibration generated when food to be cooked and/or cooking adjuvant inside of the cookware is heated up. The present invention further relates to a method for assembling a carrying plate of a cooking appliance, particularly a top plate of a cooking hob, with a vibration sensor, which carrying plate transmits vibration movements from a cookware to the vibration sensor.

Cooking processes in which food is prepared for consumption are put more and more under automatic control. For automatically controlled cooking appliances, in particular cooking hobs, vibration sensors are implemented. With said sensors the cooking progress may be better monitored, particularly when using cooking liquids, with respect to temperature increase in the food and/or of the cooking liquid.

From EP 3 413 687 A1 a method for controlling a cooking process is known, which cooking process is operated when cooking food in a cooking vessel placed on a cooking hob. A vibration sensor is arranged in the cooking hob for a detection of boiling of a cooking liquid. However, this document does not teach how to assemble said vibration sensor in order to get a best performance thereof and to get correct and unaltered measuring results.

It is an object of the present invention to provide a cooking appliance with at least one carrying plate and a method for assembling a vibration sensor which provide measuring results particularly well supporting automatic cooking processes.

The object is achieved for a cooking appliance with at least one carrying plate and at least one sensing means for the detection of vibrations according to the features of claim 1.

A cooking appliance according to the invention comprises at least one carrying plate adapted to receive cookware placed thereon. Said cooking appliance may be a cooking hob with a top plate. The cooking appliance further comprises at least one sensing means for the detection of vibration which is generated when food to be cooked and/or cooking adjuvant inside of the cookware is heated up. The food to be cooked and/or the cooking adjuvant may be a cooking liquid. A vibration sensor is, in particular in a detachable manner, attached to the carrying plate, which may be the top plate of the cooking hob, by way of fixation means which prevent relative movement between the vibration sensor and the carrying plate, in particular in the direction towards and/or away from each other.

The cooking appliance may also be an oven comprising a baking tray which receives cookware placed thereon. In this alternative embodiment, the vibration sensor is attached to the baking tray for sensing vibration at or inside said cookware.

The vibration sensor may be attached to a bottom side of the carrying plate, particularly of the top plate of the cooking hob or the baking tray inside the oven. The vibration sensor is arranged preferably in a centre region of the carrying plate.

In a specific embodiment, the vibration sensor is arranged on an electronic circuit board. This may be an advantageous solution for supporting the vibration sensor in a best way to prevent a relative movement thereof.

The fixation means may comprise a first rigid frame part which is rigidly connected to the carrying plate. Particularly, the first rigid frame part is made of plastic which is a cost-saving solution both in relation to material costs and as serving also as electrically isolating means.

In a preferred embodiment, the vibration sensor, or the electronic circuit board comprising the vibration sensor, respectively, is bordered on all sides by the first rigid frame part. With such kind of all-side delimitation unfavourable relative movements are yet further eliminated.

The first rigid frame part may be circumferentially connected to the carrying plate in order to prevent its twisting during occurrence of vibrations, what also may cause negatively influencing relative movements.

Advantageously, a second rigid frame part is connected to the first rigid frame part and the vibration sensor, or particularly the electronic circuit board comprising the vibration sensor, is clamped between the first and the second rigid frame parts. Preferably the first and the second rigid frame parts are connected with each other by way of snapping means.

In a preferred embodiment, a sealing frame part is positioned between the electronic circuit board and the first rigid frame part and/or between the electronic circuit board and the second rigid frame part. The sealing frame part is preferably made of a soft and/or flexible material, e. g. a rubber material or silicone. With such soft and/or flexible material a further increased free of clearance assembling may be realized.

In particular, the vibration sensor and/or an electronic circuit board comprising or carrying the vibration sensor is connected to a data bus of the cooking appliance. For this purpose preferably a communication cable is used, which may be connected to any element that can receive a data bus communication signal, for example a user interface unit or a power board of the cooking appliance.

Particularly, the vibration sensor and/or an electronic circuit board comprising or carrying the vibration sensor may be connected to a control unit and/or to a user interface unit of the cooking appliance by means of a connecting cable. The connection cable may be a MACS cable or any other cable, e. g. a cable used for a serial or parallel bus connection.

The object is achieved for a method for assembling a vibration sensor to a carrying plate of a cooking appliance according to the features of claim 10.

According to a further aspect of the invention, a method for assembling a vibration sensor to a carrying plate of a cooking appliance is disclosed. Said carrying plate may be a top plate of a cooking hob. The carrying plate transmits vibration movements from a cookware to the vibration sensor. The assembly comprises the assembling steps:
- a first rigid frame part is rigidly connected to the carrying plate, preferably in a first assembling step; and
- the vibration sensor is connected to the first rigid frame part in a way that prevents relative movements between vibration sensor and carrying plate, preferably in a second assembling step.

It is desirable to prevent any type of relative movements, but most favourably to prevent movements in the direction towards and/or away from each other.

Particularly, the vibration sensor is fitted into an electronic circuit board and, thereafter, the electronic circuit board comprising the vibration sensor is connected to the first rigid frame part. A preferred fitting method is soldering.

In a following assembling step, a second rigid frame part may be connected to, preferably snapped into, the first rigid frame part. The vibration sensor, in particular the electronic circuit board comprising the vibration sensor, is clamped between the first and the second rigid frame parts. Preferably, the vibration sensor or the electronic circuit board, respectively, is clamped between the frame parts with a circumferential border thereof.

A preferred embodiment is characterized by a sealing frame part which is positioned between the vibration sensor or the electronic circuit board comprising the vibration sensor, respectively, and the first rigid frame part and/or between the vibration sensor or the electronic circuit board comprising the vibration sensor, respectively, and the second rigid frame part prior to the assembling step of connecting the second rigid frame part to the first rigid frame part. The sealing frame part may be connected to the vibration sensor or to the electronic circuit board comprising the vibration sensor and, in a following assembling step, the combination of sealing frame with the vibration sensor or the electronic circuit board comprising the vibration sensor is connected to or implemented into the first rigid frame part.

In a further following assembling step, a first connector of a connecting cable may be connected to the vibration sensor or to a circuitry comprising the vibration sensor and a second connector of the connecting cable may be connected to a control unit and/or to a user interface unit of the cooking appliance. The connecting cable may be attached to the carrying plate, e. g. by way of gluing, in order to avoid its tear-off.

Novel and inventive features of the present invention are set forth in the appended claims.

The present invention will be described in further detail with reference to the drawings, in which
- FIG 1: is an exploded view of a cooking hob illustrating components and modules arranged therein;
- FIG 2: is an exploded view of a sensor arrangement illustrating a sensor circuit board and fixation frame parts; and
- FIG 3: illustrates a cross-sectional view of the sensor arrangement of FIG 2 attached to a top plate of the cooking hob.

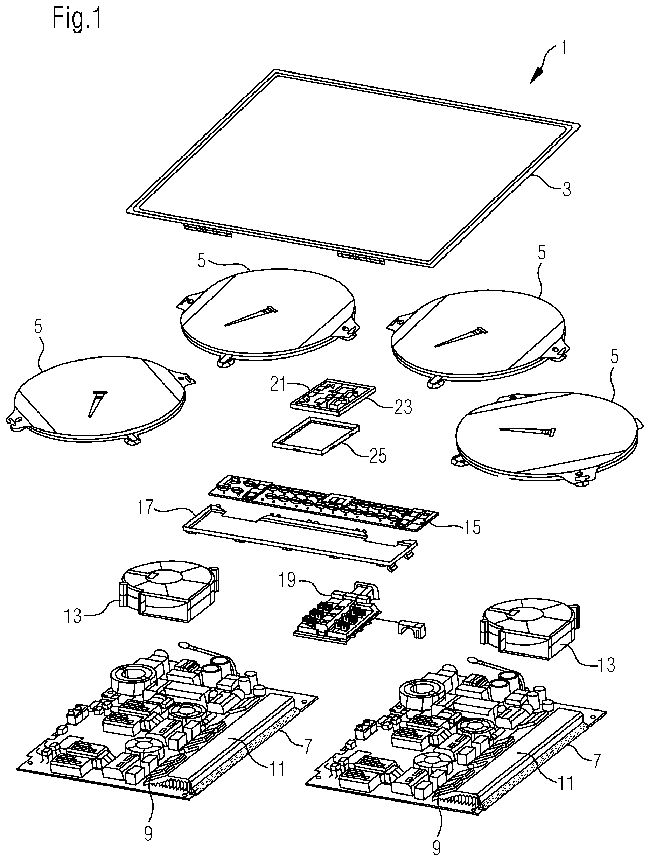

According to the illustration of FIG 1, an induction cooking hob 1 comprises a top plate 3, the upper side thereof facing a user of the induction cooking hob who can place cookware thereon for cooking processes. The top place 3 is usually composed of glass ceramic material and cooking zones are usually indicated thereon (not shown). Four cooking zones are defined by respective induction coil arrangements 5 positioned beneath the top plate 3.

The induction coils 5 are powered by means of two power boards 7 having identical structure and comprising a number of different electric and electronic components interconnected by a circuitry. In order to provide an intensified cooling effect on power electronic components 9, also integrated in the power board circuitry, a metallic cooling channel 11 is placed on each power board 7 and the power electronic components 9 of each power board 7 are attached to the outer surface of the allocated cooling channel 11. The intensified cooling effect is further increased by means of a cooling fan 13 for each power board 7, blowing cooling air into the interior of the cooling channel 11.

The induction cooking hob 1 further comprises a user interface 15 for an input of control commands by the user which user interface 15 is attached to the bottom side of the top plate 3 by means of a user interface housing 17. All electric and electronic components are electrically supplied from the domestic power supply by means of a power cable (not shown) which is connected to a mains terminal 19 inside the induction cooking hob 1

Finally, the induction cooking hob 1 is also equipped with a vibration sensor adapted to support a monitoring of the progress of the cooking process, especially for an automatic cooking program. Particularly cooking liquids inside of a cookware placed on the top plate 3 of the induction cooking hob 1 cause the cookware to start to vibrate at a certain temperature level, which vibration assumes a specific degree when the cooking liquid begins to boil. The start of the boiling state is sensible by said vibration sensor.

The vibration sensor is attached to the bottom surface of the top plate 3, which top plate 3 passes on the vibration signals from the cookware to the vibration sensor. In order to provide a proper arrangement of the vibration sensor and its suitable connection to a control unit arranged in the user interface 15, the sensor is arranged on a sensor printed circuit board 21 which also comprises connection means. For a firm and secure attachment the sensor printed circuit board 21 is encased by a first frame part 23 and a second frame part 25 as will be explained as follows.

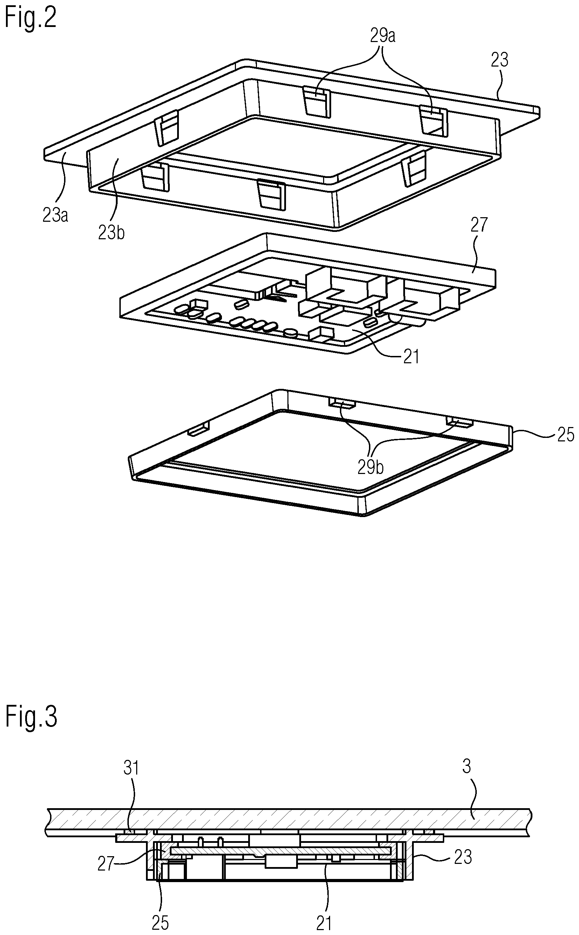

With reference to FIG 2, the arrangement of the sensor printed circuit board 21 within the first and second frame parts 23, 25 is described. As can be seen in FIG 2, a first frame part 23 is of a rectangular shape in order to receive the sensor printed circuit board 21, also being shaped rectangularly. The first frame part 23 is made of a plastic material and comprises, in its installation position, an upper, horizontal frame portion 23a which is crossed (see FIG 3) by a vertical frame portion 23b. The vertical frame portion 23b forms an outer boundary and an inner section of the horizontal frame portion 23a provides an upper stop surface for the sensor printed circuit board 21 after its integration in the first frame part 23 (see FIG 3).

The second frame part 25 is also made of a plastic material and has a rectangular shape. Its outer dimensions are adapted to the inner dimensions of the vertical frame portion 23b of the first frame part 23 in a way that the second frame part 25 is arrangeable in the interior of the vertical frame portion 23b at least without substantial clearance. After arrangement of the second frame part 25 within the vertical frame portion 23b its upper surface provides a lower stop surface for the sensor printed circuit board. In this assembling position, upper and lower stop surfaces form a sandwich-like holding mechanism for the sensor printed circuit board 21.

For a particular firm arrangement of the sensor printed circuit board 21 between first 23 and second 25 frame parts avoiding movements of these parts relative to each other, the sensor printed circuit board 21 is bordered by a sealing frame part 27 which is of a U-shaped cross section and encompasses the outer edge of the sensor printed circuit board 21 on all sides. The sealing frame part 27 is made of a soft and/or flexible material, like temperature-resistant rubber or silicone, and allows a tight clamping of the outer edge of sensor printed circuit board 21 between first 23 and second 25 frame parts. The connection of the second frame part 25 with the first frame part 23 is realized by snapping means 29a arranged at the vertical frame portion 23b and, as counterparts, by snapping means 29b arranged at the second frame part 25.

FIG 3 illustrates the installation situation of the arrangement of the sensor printed circuit board 21 between first 23 and second 25 frame parts in the induction cooking hob 1. This figure shows a cross-sectional side view of a centre region of the top plate 3. The sensor printed circuit board arrangement is attached to said centre region by means of gluing. An adhesive beading 31 between an outer section of the horizontal frame portion 23a and the bottom side of the centre region arranges for a permanent fixing of the sensor printed circuit board arrangement.

The manufacturing of the sensor printed circuit board arrangement during the assembly of the induction cooking hob 1 is as follows. First, the adhesive beading is applied on the bottom side of the centre region of the top plate 3, followed by pressing the first frame part 23 against the bottom side of the top plate 3 until the top edge of the vertical frame portion 23b rests on the bottom surface of the top plate 3. In that position, the adhesive beading is also applied on the upper surface of the outer section of the horizontal frame portion 23a, thus realizing a permanent bonded joint between first frame part 23 and top plate 3. Only thereafter, the sensor printed circuit board 21 is implemented in the first frame part 23 and the mounting of the second frame part 25 finalizes the assembling.

Although an illustrative embodiment of the present invention has been described herein with reference to the accompanying drawing, it is to be understood that the present invention is not limited to that precise embodiment, and that various other changes and modifications may be affected therein by one skilled in the art without departing from the scope or spirit of the invention. All such changes and modifications are intended to be included within the scope of the invention as defined by the appended claims.

### List of reference numerals

- 1: induction cooking hob
- 3: top plate
- 5: induction coils arrangement
- 7: power board
- 9: power electronic component
- 11: cooling channel
- 13: cooling fan
- 15: user interface
- 17: user interface housing
- 19: mains terminal
- 21: sensor printed circuit board
- 23: first frame part
- 23a: horizontal frame portion
- 23b: vertical frame portion
- 25: second frame part
- 27: sealing frame part
- 29a,b: snapping means
- 31: adhesive beading

## Claims

1. A cooking appliance with at least one carrying plate (3) adapted to receive cookware placed thereon, in particular a cooking hob (1) with a top plate, and at least one sensing means for the detection of vibration generated when food to be cooked and/or cooking adjuvant inside of the cookware is heated up, the food to be cooked and/or cooking adjuvant in particular being a cooking liquid, wherein a vibration sensor is, in particular detachably, attached to the carrying plate (3) by way of fixation means which prevent relative movement between the vibration sensor and the carrying plate (3), in particular in the direction towards and/or away from each other.

2. The cooking appliance according to claim 1, wherein the vibration sensor is attached to a bottom side of the carrying plate (3), preferably in a centre region thereof.

3. The cooking appliance according to claim 1 or 2, wherein the vibration sensor is positioned on an electronic circuit board (21).

4. The cooking appliance of anyone of the preceding claims, wherein the fixation means comprise a first rigid frame part (23), particularly a plastic frame part, the first rigid frame part (23) being rigidly connected to the carrying plate (3).

5. The cooking appliance according to claim 4, wherein the vibration sensor, particularly the electronic circuit board (21) comprising the vibration sensor, is bordered on all sides by the first rigid frame part (23).

6. The cooking appliance according to claim 4 or 5, wherein the first rigid frame part (23) is circumferentially connected to the carrying plate (3).

7. The cooking appliance according to anyone of the claims 4 to 6, wherein a second rigid frame part (25) is connected to the first rigid frame part (23), preferably under use of snapping means (29a, 29b), wherein the vibration sensor, in particular the electronic circuit board (21) comprising the vibration sensor, is clamped between the first (23) and the second (25) rigid frame parts.

8. The cooking appliance according to claim 7, wherein a sealing frame part (27) is positioned between the electronic circuit board (21) and the first rigid frame part (23) and/or between the electronic circuit board (21) and the second rigid frame part (25).

9. The cooking appliance according to anyone of the preceding claims, wherein the vibration sensor and/or an electronic circuit board (21) comprising the vibration sensor is/are connected to a data bus, preferably by an communication cable, more preferably an MACS cable, to any element that can received a data bus communication such as a user interface unit or a power board of the cooking appliance.

10. A method for assembling a vibration sensor to a carrying plate (3) of a cooking appliance, particularly to a top plate of a cooking hob (1), the carrying plate (3) transmitting vibration movements from a cookware to the vibration sensor, wherein the assembly comprises the assembling steps:
- a first rigid frame part (23) is rigidly connected to the carrying plate (3), preferably in a first assembling step; and
- the vibration sensor is connected to the first rigid frame part (23) in a way that prevents relative movement between vibration sensor and carrying plate (3), in particular in the direction towards and/or away from each other, preferably in a second assembling step.

11. The method of claim 10, wherein the vibration sensor is fitted, particularly by soldering, into an electronic circuit board (21) and, thereafter, the electronic circuit board (21) comprising the vibration sensor is connected to the first rigid frame part (23).

12. The method of claim 10 or 11, wherein, in a following assembling step, a second rigid frame part (25) is connected to, preferably snapped into, the first rigid frame part (23), wherein the vibration sensor, in particular the electronic circuit board (21) comprising the vibration sensor, is clamped, particularly with a circumferential border thereof, between the first (23) and the second (25) rigid frame parts.

13. The method according to claim 12, wherein a sealing frame part (27) is positioned between the electronic circuit board (21) and the first rigid frame part (23) and/or between the electronic circuit board (21) and the second rigid frame part (25) prior to the assembling step of connecting the second rigid frame part (25) to the first rigid frame part (23).

14. The method according to claim 13, wherein the sealing frame part (27) is connected to the electronic circuit board (21) and, in a following assembling step, the combination of the sealing frame part (27) with the electronic circuit board (21) is connected to the first rigid frame part (23).

15. The method of anyone of the claims 9 to 14, wherein, in a following assembling step, a first connector of a connecting cable is connected to the vibration sensor or to a circuitry comprising the vibration sensor and a second connector of the connecting cable is connected to a control unit and/or to a user interface (15) unit of the cooking appliance.
